# EUROPEAN PATENT APPLICATION

(11) **EP 2 632 021 A1**
(43) Date of publication of application: **28.08.2013**
(21) Application number: 11834482.9
(22) Date of filing: 21.10.2011
(51) Int. Cl.: H02J 7/02

(54) **BATTERY SYSTEM**

(30) Priority: 21.10.2010 JP 2010236472
(71) Applicant: Hitachi, Ltd., Tokyo 100-8280 (JP)
(72) Inventor: SAKABE, Kei, Hitachi-shi Ibaraki 319-1292 (JP); FUTAMI, Motoo, Hitachi-shi Ibaraki 319-1292 (JP); NAKAO, Ryohei, Hitachi-shi Ibaraki 319-1292 (JP); INOUE, Takeshi, Hitachi-shi Ibaraki 319-1292 (JP); KUDO, Akihiko, Hitachinaka-shi Ibaraki 312-8505 (JP)
(74) Representative: MERH-IP Matias Erny Reichl Hoffmann
(86) International application number: PCT/JP2011/074322
(87) International publication number: WO 2012/053643

(57) **Abstract**

A battery system includes an assembled battery having a plurality of batteries connected in series, a discharge circuit having a first resistor and a discharge switch connected in series, which is connected in parallel to the respective batteries to discharge the respective batteries, a comparator that compares voltages of the respective batteries with a given voltage through the first resistor, and a diagnostic circuit that conducts a fault diagnosis of the discharge switch on the basis of comparison results of the comparator.

## Description

### Technical Field

The present invention relates to a battery system.

### Background Art

An assembled battery in which a plurality of secondary batteries are connected to each other have advantages that a high voltage, a large current, and a large electric power are easily obtainable as compared with an electric cell. Therefore, the assembled battery is put into practical use as electric storage means for a hybrid vehicle, an electric vehicle, a hybrid rail vehicle, and a UPS.

Because the characteristics of the respective secondary batteries configuring the assembled battery are varied at the time of manufacture, there is a need to monitor a variation of the amount of charge in the respective batteries at the point of use depending on the type of battery, and control the variation in the amount of charge to fall within a given range. As a control method thereof, there has been known a system of discharging a battery larger in the amount of charge than others through a resistor and a switch. In a battery control device using this system, the switch and a measuring circuit for monitoring the variation in the amount of charge are integrated into an IC for the purpose of reducing the number of parts. However, if a short-circuit fault occurs in the switch, the battery is overdischarged. Also, if an open fault occurs in the switch, the variation in the amount of battery in the battery cannot be controlled. For that reason, there is a need to diagnose whether the switch fails, or not. The IC in the battery control device may have a function of diagnosing the switch. The IC that diagnoses a charge amount adjustment switch has been known as disclosed in, for example, Patent Literatures 1 and 2.

### Citation List

### Patent Literature

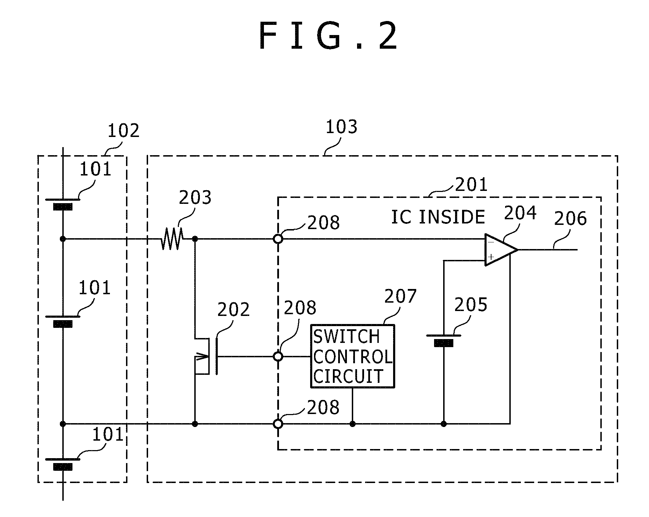

Patent Literature 1: Japanese Unexamined Patent Application Publication No. 2005-318750 (refer to paragraph 0038, FIG. 2)
Patent Literature 2: Japanese Unexamined Patent Application Publication No. 2005-318751 (refer to paragraph 0039, FIG. 2)

### Summary of Invention

### Technical Problem

Incidentally, in recent years, the capacity of battery is increased, and the amount of current necessary for discharge to equalize the variation in the amount of charge is increased. This makes it difficult to integrate the switch into the IC, and the switch needs to be externally attached to the IC. However, a dedicated signal line needs to be provided for diagnosing the switch, resulting in such a problem that the number of pins in the IC is increased. As the number of pins in the IC is increased, the reliability is lessened due to an increase in the costs and an increase in the soldered portions, and the substrate surface is increased. For that reason, there is a need to decrease the number of pins in the IC as large as possible. Technical Problem

According to a first aspect of the present invention, there is provided a battery system, including: an assembled battery having a plurality of batteries connected in series; a discharge circuit having a first resistor and a discharge switch connected in series, which is connected in parallel to the respective batteries to discharge the respective batteries; a comparator that compares voltages of the respective batteries with a given voltage through the first resistor; and a diagnostic circuit that conducts a fault diagnosis of the discharge switch on the basis of comparison results of the comparator.
According to a second aspect of the present invention, in the battery system according to the first aspect, the diagnostic circuit can conduct the fault diagnosis of the first switch on the basis of the comparison results of the comparator when conducting an intermittent operation of the discharge switch.
According to a third aspect of the present invention, in the battery system according to the second aspect, it is preferable that the diagnostic circuit diagnoses that the discharge switch is in failure if an output of the comparator is not changed when conducting the intermittent operation of the discharge switch.
According to a fourth aspect of the present invention, the battery system according to any one of the first to third aspects may include a voltage measurement circuit that measures the voltages of the respective batteries. In the battery system, it is preferable that there is provided a first common portion that communizes at least a part of a line for connecting the batteries to the discharge circuit, and at least a part of a line for connecting the batteries to the voltage measurement circuit.
According to a fifth aspect of the present invention, in the battery system according to the fourth aspect, there may be provided a second common portion that communizes at least a part of the line for connecting the batteries to the voltage measurement circuit, and at least a part of a line for controlling the discharge circuit.
According to a sixth aspect of the present invention, in the battery system according to the fifth aspect, it is preferable that a second resistor is disposed between the first common portion and the second common portion.
According to a seventh aspect of the present invention, in the battery system according to the sixth aspect, a third resistor may be disposed between the first resistor and the discharge switch, and the comparator may be connected at a connection point between the first resistor and the third resistor.
According to an eighth aspect of the present invention, in the battery system according to the seventh aspect, it is preferable that the comparator is connected from the connection point of the first resistor and the third resistor through a fourth resistor.
According to a ninth aspect of the present invention, in the battery system according to any one of the first to eighth aspects, the diagnostic circuit can conduct the fault diagnosis of the discharge switch when starting the battery system.
According to a tenth aspect of the present invention, in the battery system according to any one of the first to ninth aspects, it is preferable that a voltage at which the battery is in an overdischarging state is set for the given voltage of the comparator. Advantageous Effects of Invention

According to the present invention, there can be provided a battery system that can realize diagnosis of the discharge switch externally attached to an IC, for equalizing a variation in the amount of discharge.

### Brief Description of Drawings

[FIG. 1]

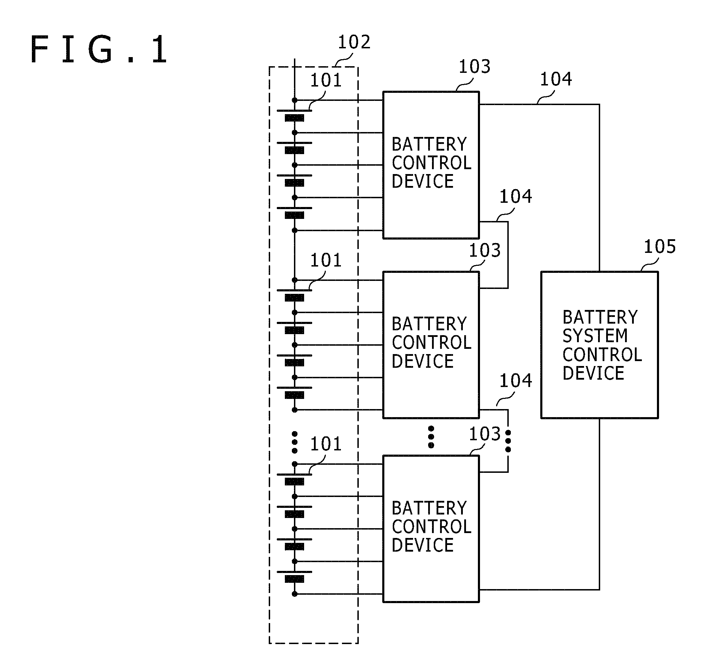

   FIG. 1 is a diagram schematically illustrating a configuration of a battery control device and a battery system using the device according to an embodiment.
[FIG. 2]
   FIG. 2 is a diagram illustrating an IC 201.
[FIG. 3]

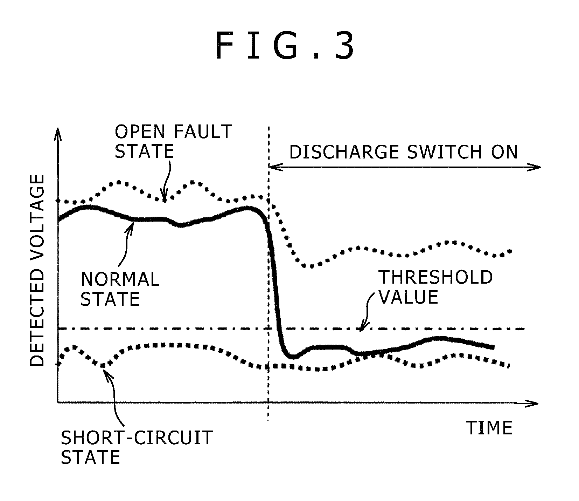

   FIG. 3 is a diagram illustrating a relationship between the operation of a discharge switch 202 and a detection voltage.
[FIG. 4]

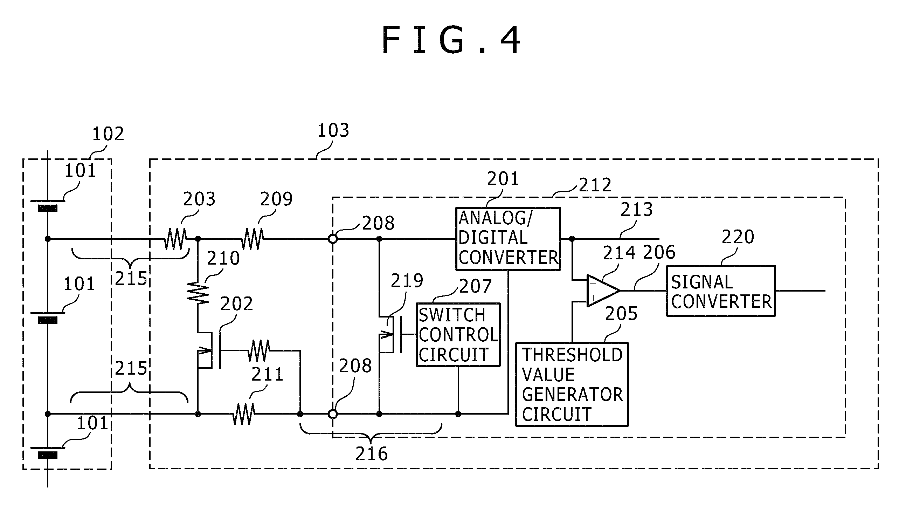

   FIG. 4 is a diagram illustrating another configuration of the battery control device 103.
[FIG. 5]

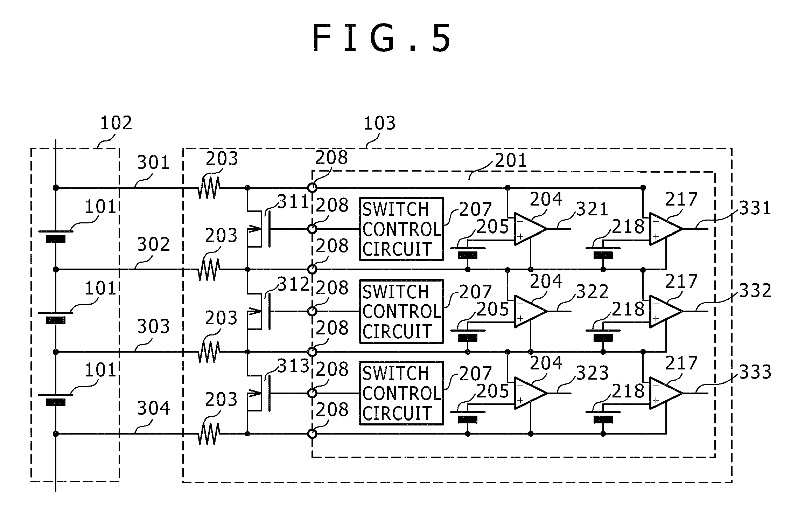

   FIG. 5 is a diagram illustrating another configuration of the battery control device.
[FIG. 6]

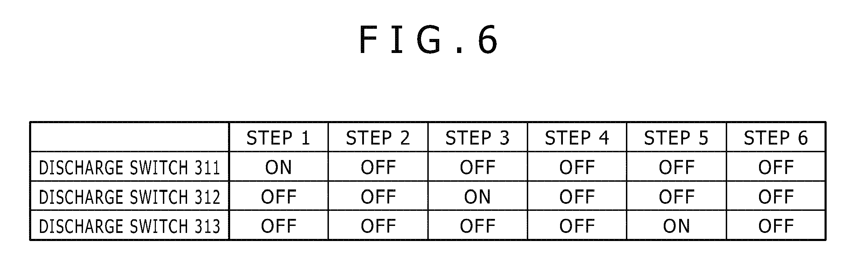

   FIG. 6 is a diagram illustrating a drive procedure of discharge switches 311 to 313 illustrated in FIG. 5.
[FIG. 7]

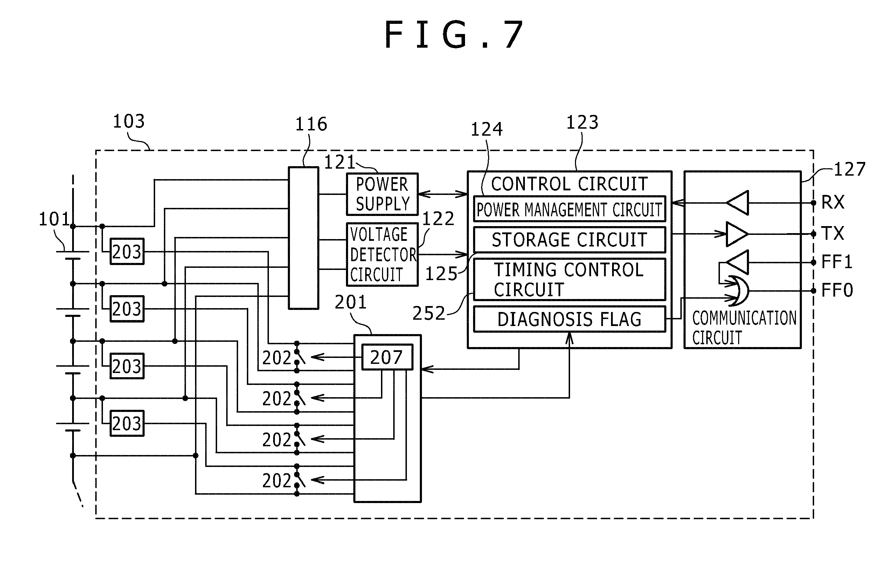

   FIG. 7 is a block diagram schematically illustrating a configuration of the battery control device 103.
[FIG. 8]

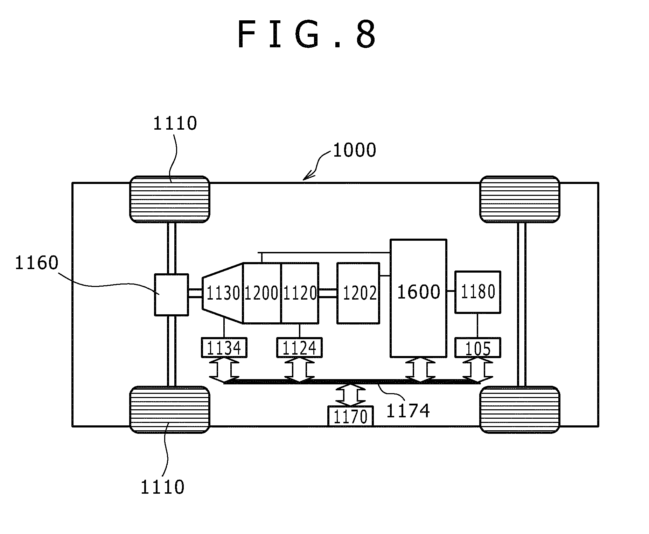

   FIG. 8 is a block diagram schematically illustrating a configuration of a hybrid electric vehicle.

### Description of Embodiments

Hereinafter, embodiments of the present invention will be described with reference to the accompanying drawings. FIG. 1 is a diagram schematically illustrating a configuration of a battery control device and a battery system using the device according to an embodiment. The battery system according to the embodiment includes an assembled battery 102 having a plurality of batteries 101 electrically connected in series with each other, one or a plurality of battery control devices 103 that is electrically connected to the respective batteries 101, measures a voltage or a temperature of the batteries 101, and can discharge the respective batteries 101, individually, and a battery system control device 105 that communicate a signal with the battery control devices 103 through signal lines 104, and conducts a state estimation of the batteries 101 or the control of discharge. This embodiment illustrates an example in which a lithium-ion battery is used as each of the batteries 101. However, the type of batteries 101 is not limited to the lithium-ion battery.

The battery system control device 105 receives the voltage of the respective batteries 101 and temperature information which are measured by the battery control devices 103 through the signal lines 104, and estimates a variation in the amount of charge in the respective batteries 101 on the basis of the received information. As a result, the battery system control device 105 can calculate the amount of discharge of the respective batteries 101 necessary for eliminating the variation in the amount of charge in the respective batteries 101. The battery system control device 105 issues an instruction for discharging the respective batteries 101 to the respective battery control devices 103 through the signal lines 104 on the basis of the calculation results. With the above configuration, the variation in the amount of discharge in the respective batteries 101 is equalized, and a charge/discharge range of the available batteries 101 can be expanded.

FIG. 7 is a block diagram schematically illustrating a configuration of the battery control device 103 according to the embodiment. In an example illustrated in FIG. 7, input side terminals of each battery control device 103 are electrically connected to the four batteries 101. A positive electrode side and a negative electrode side of each battery 101 are electrically connected to an input circuit 116 of the battery control device 103. The input circuit 116 includes a multiplexer. A power circuit 121 includes, for example, a DC/DC converter, and converts an electric power from each battery 101 into a given constant voltage, and applied to the respective circuits within the battery control devices 103 as a drive power supply. Also, a voltage from the power circuit 121 is applied to a comparator circuit for determining a state as a comparative reference voltage.

A voltage detector circuit 122 has a circuit for converting an inter-terminal voltage of each battery 101 into a digital value. Each inter-terminal voltage converted into the digital value is fed to a control circuit 123, and retained in an internal storage circuit 125. The voltage information is used for diagnosis, or transmitted to the battery system control device 105 illustrated in FIG. 1 through the signal lines 104.

The control circuit 123 has a calculation function, and includes the storage circuit 125, a power management circuit 124, and a timing control circuit 252 that periodically conducts the detection of various voltages and a state diagnosis. The storage circuit 125 includes, for example, a register circuit, and stores the inter-terminal voltage of the respective batteries 101 detected by the voltage detector circuit 122 in association with the respective batteries 101. Also, the storage circuit 125 readably retains the other detection values at predetermined addresses. The power management circuit 124 manages a state in the power circuit 121.

The control circuit 123 is connected with a communication circuit 127. The control circuit 123 can receive a signal from the external of the battery control device 103 through the communication circuit 127. For example, the control circuit 123 receives, for example, a communication command from the battery system control device 105 at an RX terminal. The communication command is transmitted from the communication circuit 127 to the control circuit 123 where the contents of the communication command are decoded, and processing is conducted according to the communication command contents. For example, the communication command includes a communication command for requesting a measured value of the inter-terminal voltage of the respective batteries 101, a communication command for requesting discharge operation for adjusting the charging state of the respective batteries 101, a communication command (wake up) for starting the operation of the battery control device 103, a communication command (sleep) for stopping the operation, and a communication command for requesting address setting.

A positive electrode side of the top battery 101 illustrated in FIG. 7 is electrically connected to one end of a discharge switch 202 of the battery control device 103 through a first resistor 203. The other end of the discharge switch 202 is electrically connected to a negative electrode side of the corresponding battery 101. A series circuit of the first resistor 203 and the discharge switch 202 configure a discharge circuit. Likewise, the other batteries 101 are each provided with a discharge circuit including the series circuit of the discharge switch 202 and the first resistor 203. The battery control devices 103 is equipped with an IC 201 for controlling and diagnosing the discharge circuits provided for the respective batteries 101. The details of the IC 201 will be described later.

When the IC 201 determines that the discharge circuit is abnormal, the IC 201 outputs the diagnosis result to the control circuit 123. The control circuit 123 outputs a signal indicative of an abnormality of the discharge circuit from a 1-bit transmit terminal FFO of the communication circuit 127. The output abnormality signal is transmitted to the battery system control device 105 through the signal lines 104.

FIG. 2 is a diagram illustrating the IC 201. As described above, the battery control device 103 includes the discharge circuit having the series circuit of the discharge switch 202 and the first resistor 203, and the IC 201 that controls and diagnoses the discharge circuit. Thus, the discharge circuit is installed outside of the IC 201 so as to prevent the IC 201 from being damaged by heat generation of the discharge circuit. In this embodiment, an FET is used for the discharge switch. However, the discharge switch is not limited to the FET.

In the discharge circuit having the discharge switch 202 and the first resistor 203 electrically connected in series, one end of the first resistor 203 is electrically connected to one end of the discharge switch 202, and the other end of the first resistor 203 is electrically connected to one end of the battery 101. Also, the other end of the discharge switch 202 is electrically connected to the other end of the battery 101. With the above configuration, the amount of discharge in the battery 101 can be controlled with the use of the discharge switch 202. Also, a charging energy of the battery 101 can be converted into heat and discharged while limiting a discharge current amount by the first resistor 203. A value of the first resistor 203 is, for example, 12 Ω.

The adjustment for equalizing the charging states (terminal voltages) of the plurality of batteries 101 electrically connected in series is implemented, for example, by the following procedure.

First, in the battery control devices 103, the respective terminal voltages of the plurality of batteries 101 are periodically detected, and the detected terminal voltages of the respective batteries 101 are retained in a register. The register is rewritten every time the terminal voltages of the respective batteries 101 are detected. When a transmission request instruction signal for the terminal voltages of the respective batteries 101 is transmitted from the battery system control device 105, the battery control devices 103 read the terminal voltages of the respective batteries 101 which are detected and retained in the register, and transmit the read terminal voltages to the battery system control device 105.

Then, the battery system control device 105 calculates an intermediate value on the basis of a difference between the highest terminal voltage and the lowest terminal voltage among the terminal voltages of the respective batteries 101, which are transmitted from the battery control devices 103. The battery system control device 105 compares the calculated intermediate value with the terminal voltages of the respective batteries 101 transmitted from the battery control devices 103. If the difference therebetween is equal to or higher than a given value, the battery system control device 105 targets the subject battery 101 for the charging state adjustment using the first resistor 203, and also calculates a discharge time using the first resistor 203 on the basis of the difference. Then, the battery system control device 105 generates a switching instruction signal of the discharge switch 202 for discharging the battery 101 to be subjected to the charging state adjustment on the basis of the calculated discharge time of the battery 101 to be subjected to the charging state adjustment. The battery system control device 105 transmits the switching instruction signal to the battery control devices 103 corresponding to the battery 101 to be subjected to the charging state adjustment.

The battery control device 103 that receives the switching instruction signal generates a switching drive signal on the basis of the switching instruction signal, outputs the switching drive signal to the discharge switch 202 for discharging the battery 101 to be subjected to the charging state adjustment, and controls the drive (on/off) of the switch. As a result, the battery 101 to be subjected to the charging state adjustment discharges an electric energy to the first resistor 203 while the discharge switch 202 corresponding to the battery 101 to be subjected to the charging state adjustment turns on. With this discharging operation, the electric energy charged in the battery 101 to be subjected to the charging state adjustment is consumed as a heat by the first resistor 203, to adjust the charging state (terminal voltage) of the battery 101 to be subjected to the charging state adjustment.

The IC 201 includes a comparator 204, a threshold value generator circuit 205, a comparison result output 206, a switch control circuit 207, and a terminal 208. The switch control circuit 207 generates a signal for turning on/off the discharge switch 202. As a result, the battery control devices 103 can discharge the battery 101 larger in the amount of discharge than others, and control the variation in the amount of discharge.

In this example, a voltage to be applied to the resistor 203 is changed according to a current flowing in the discharge switch 202. For that reason, a voltage to be applied to the comparator 204 is also changed according to the current flowing in the discharge switch 202. The comparator 204 compares the voltage applied to the discharge switch 202 with an output voltage of the threshold value generator circuit 205, for example, 2.5 V. If the latter is larger, the comparator 204 outputs a true to the comparison result output 206, and if the former is larger, the comparator 204 outputs a false thereto. A rated voltage of the lithium-ion battery 101 in the embodiment is 3.6 V, and an inter-terminal voltage is not reduced to 3 V or lower in a normal state. Accordingly, the inter-terminal voltage 2.5 V of the threshold value generator circuit 205 corresponds to the inter-terminal voltage when the lithium-ion battery 101 of the embodiment is an abnormal overdischarging state.

FIG. 3 illustrates an example of a relationship between the operation of a discharge switch 202 and a detection voltage. When the discharge switch 202 normally operates, if the discharge switch 202 is off, a voltage to be applied to the comparator 204 is equal to or higher than a threshold value, and a false is output to the comparison result output 206. If the discharge switch 202 is on, the voltage to be applied to the comparator 204 is equal to or lower than the threshold value, and a true is output to the comparison result output 206.

On the other hand, when, for example, an open fault occurs in the discharge switch 202, even if the discharge switch 202 is off, the voltage to be applied to the comparator 204 is equal to or higher than the threshold value. For that reason, in this case, the output to the comparison result output 206 remains fault regardless of an on or off state of the discharge switch 202. Also, if a short-circuit fault occurs in the discharge switch 202, even if the discharge switch 202 turns off, the voltage to be applied to the comparator 204 is equal to or lower than the threshold value. For that reason, the true is output to the comparison result output 206 regardless of the on or off state of the discharge switch 202.

Thus, when the battery system normally operates, the comparison result output 206 is changed according to the output of the switch control circuit 207, and not changed when the failure occurs in the discharge switch 202. Under the circumstances, the failure of the discharge switch 202 can be detected according to whether the change is present, or not. The failure determination of the discharge switch 202 based on the comparison result output 206 may be implemented by the control circuit 123 of the battery control devices 103, or may be implemented by the battery system control device 105.

FIG. 4 illustrates another configuration of the battery control device 103. This configuration is larger in the number of parts than the configuration illustrated in FIG. 2. However, the degree of freedom of the discharge switch 202 and the reliability of the system are improved.

The configuration illustrated in FIG. 4 includes, in addition to the configuration illustrated in FIG. 2, a second resistor 211 and a third resistor 210 which give latitude in selection of the discharge switch 202, and a fourth resistance 209 which gives latitude in design of the switch control circuit 207. Thus, with the provision of the third resistor 210, a relationship between the discharge current and the threshold value for comparison can be freely set. Also, with the provision of the second resistor 211 and the fourth resistance 209, an operating potential of a switch driver circuit 219, and an operating potential of the discharge switch 202 can be adjusted, and the latitude in selection of those switches can be increased.

Also, a part of a discharge path of the batteries and a part of a voltage measurement line of the batteries are commonalized as first common portions 215, and the number of lines is decreased. In this configuration, when the discharge switch 202 is on at the time of measuring the battery voltage, it is difficult to measure an accurate battery voltage due to a voltage drop developed in the first resistor 203. Under the circumstances, when the battery voltage is measured, the discharge switch 202 turns off by the switch control circuit 207 to reduce the amount of voltage drop to 0. This makes it possible to accurately measure the battery voltage.

In the configuration illustrated in FIG. 4, the comparator 204 illustrated in FIG. 2 is replaced with an analog/digital converter 212 and a digital comparator 214. The analog/digital converter 212 is connected to the voltage measurement line, and converts a voltage of the batteries 101 into a digital value as with the voltage detector circuit 122 of FIG. 7. The voltage of the batteries 101 which has been converted into a digital value is output to the control circuit 123 from a voltage output 213. As a result, in the battery control devices 103, the voltage detector circuit 122 is omitted, and a circuit that conducts a fault diagnosis of the discharge switch 202 and a circuit that measures the voltage of the battery 101 can be commonalized, and a circuit scale can be reduced. One end of the digital comparator 214 is connected to a connection point between the first resistor 203 and the third resistor 210 through the analog/digital converter 212 and the fourth resistance 209. The threshold value generator circuit 205 corresponds to the digital comparator 214, and therefore outputs a digital value.

A signal converter 220 converts the comparison result output 206. An output from the signal converter 220 is a signal that periodically fluctuates at 1 Hz, for example, when the comparison result output 206 is false, and a signal having no periodic fluctuation when the comparison result output 206 is true. This makes it possible to prevent erroneous determination caused by stiction of a signal output and disconnection of the signal line.

Also, according to the configuration illustrated in FIG. 4, one end of the switch driver circuit 219 is connected to an input of the analog/digital converter 212, and the other end thereof is connected to a second common portion 216. The second common portion 216 is configured to commonalize a part of the voltage measurement line and a part of a line for controlling the discharge switch 202. With this configuration, the number of terminals 208 of the IC is reduced. As a result, the chip area of the IC can be reduced.

FIG. 5 illustrates another configuration of the battery control device. In this configuration, second comparators 217 and second threshold value generator circuits 218 are added to the configuration illustrated in FIG. 2. In this configuration, discharge switches 311, 312, and 313 operate in an appropriate order to enable fault detection of the discharge switches 311, 312, and 313 as well as the disconnection detection of lines 302 and 303. Further, the overdischarge of the batteries 101 and the short-circuit of the discharge switches 311, 312, and 313 can be distinguished from each other with the use of the output of the second comparators 217.

In the configuration illustrated in FIG 5, one end of the discharge switches 311, 312, and 313 is electrically connected between lines 301 to 304 connecting the battery control devices 103 and the assembled battery 102, and the first resistor 203. With this configuration, for example, each of the comparators 204 can compare the voltage of the battery 101 with the voltage of the threshold value generator circuit 205 regardless of the on or off state of the discharge switch 311. As in the configuration illustrated in FIG. 4, one end of the discharge switch 311 may be electrically connected between the first resistor 203 and the IC 201. As a result, a heating generation portion caused by discharge is dispersed to reduce a thermal request.

In the configuration illustrated in FIG. 5, the IC 201 drives the discharge switches 311 to 313 through the switch control circuit 207 in order illustrated in FIG. 6, and conducts the fault diagnosis of the discharge switches 311 to 313 and the disconnection detection of the lines 302 and 303. A method of diagnosing the discharge switches 311 to 313 is identical with that of the other configuration. The disconnection detection diagnoses that the line 302 is disconnected, for example, in the case where when operation is advanced from Step 3 to Step 4, a comparison result output 322 remains true, and if the operation is further advanced to Step 5, the comparison result output 322 becomes false.

Also, the configuration illustrated in FIG. 5 includes the second comparators 217 and the second threshold value generator circuits 218 in addition to the configuration illustrated in FIG. 4. It can be detected whether the voltage fluctuates due to a change in the discharge switches 311 to 313, or not, by reducing an output of each second threshold value generator circuit 218 to, for example, half of the threshold value generator circuit 205. As a result, the short-circuit fault of the discharge switches 311 to 313 and the disconnection of the lines 302 and 303 can be distinguished. In the above-mentioned example, for example, if the comparison result output 322 is true, and 332 is false in Step 3, it is diagnosed that the short-circuit fault occurs in the discharge switch 312. Conversely, if both of the comparison result outputs 322 and 332 are true, it is diagnosed that the line 302 is disconnected.

The drive of the discharge switch illustrated in FIG. 6 may be conducted at any time of starting or finishing the system, or during the operation of the system. When the drive of the discharge switch is conducted at the start time, a user can confirm whether the abnormality is present, or not, before really operating the system, and comfortably use the system. Also, when the drive of the discharge switch is conducted at the finish time, for example, it can be confirmed whether the discharge switch is short-circuited, or not, and it can be determined whether the system can be left for a long time, or not. When the drive of the discharge switch is conducted, for example, it is confirmed whether the disconnection is present, or not, and it can be confirmed that the voltages of the respective batteries 101 can be precisely read.

The battery system according to the present invention can be used for a variety of devices using assembled battery means such as a power supply for transportation such as a hybrid vehicle, an electric vehicle, or a hybrid rail vehicle, a power supply for a mobile device such as a power tool or a notebook computer, or a backup power supply such as a UPS.

FIG. 8 is a diagram schematically illustrating a configuration of a hybrid electric vehicle to which the battery system of the present invention is applied. In a vehicle 1000 are mounted an engine 1120, a first rotating electrical machine 1200, a second rotating electrical machine 1202, and a battery 1180. The above-mentioned battery system is applied to the battery 1180, and includes the assembled battery 102 and the battery control devices 103. The battery 1180 supplies a DC power to the rotating electrical machines 1200 and 1202 through a power conversion device 1600 if a driving force by the rotating electrical machines 1200 and 1202 is necessary, and receives a DC power from the rotating electrical machines 1200 and 1202 at the time of regeneration travel. The transfer of the DC power between the battery 1180, and the rotating electrical machines 1200 and 1202 is conducted through the power conversion device 1600. Also, although not shown, a battery that supplies a low voltage power (for example, 14 volt power) is mounted in the vehicle, and supplied the DC power to the control circuit which will be described below.

A rotating torque by the engine 1120 and the rotating electrical machines 1200, 1202 is transmitted to the front wheels 1110 through a transmission 1130 and a differential gear 1160. The transmission 1130 is controlled by a transmission control device 1134, and the engine 1120 is controlled by an engine control device 1124. The battery 1180 is controlled by the battery system control device 105. The transmission control device 1134, the engine control device 1124, the battery system control device 105, the power conversion device 1600, and an integrated control device 1170 are connected by a communication line 1174.

The integrated control device 1170 is a control device higher in level than the transmission control device 1134, the engine control device 1124, the power conversion device 1600, and the battery system control device 105. The integrated control device 1170 receives information indicative of respective states of the transmission control device 1134, the engine control device 1124, the power conversion device 1600, and the battery system control device 105 from those devices through the communication line 1174. The integrated control device 1170 calculates control instructions of the respective control devices on the basis of those information. The calculated control instructions are transmitted to the respective control devices through the communication line 1174.

The battery system control device 105 outputs a charge/discharge status of the battery 1180, and states of the respective unit cell batteries configuring the battery 1180 to the integrated control device 1170 through the communication line 1174. When the integrated control device 1170 determines that the battery 1180 needs to be charged on the basis of the information from the battery system control device 105, the integrated control device 1170 issues an instruction for power generation drive to the power conversion device 1600. Also, the integrated control device 1170 mainly manages the output torques of the engine 1120, and the rotating electrical machines 1200, 1202, and calculates a total torque of the output torque of the engine 1120 and the output torques of the rotating electrical machines 1200 and 1202, and a torque distribution ratio. The integrated control device 1170 transmits control instructions based on the calculation processing results to the transmission control device 1134, the engine control device 1124, and the power conversion device 1600. The power conversion device 1600 controls the rotating electrical machines 1200 and 1202 to generate a torque output or a generated power according to the instruction.

The power conversion device 1600 is equipped with a power semiconductor configuring an inverter for driving the rotating electrical machines 1200 and 1202. The power conversion device 1600 controls the switching operation of the power semiconductor on the basis of an instruction from the integrated control device 1170. The rotating electrical machine 1200 and 1202 are driven as electric motors or power generators.

When the rotating electrical machines 1200 and 1202 are driven as the electric motors, a DC power is supplied from a high-voltage battery 1180 to a DC terminal of an inverter in the power conversion device 1600. The power conversion device 1600 controls the switching operation of the power semiconductor, converts the supplied DC power into a three-phase AC power, and supplies the three-phase AC power to the rotating electrical machines 1200 and 1202. On the other hand, when the rotating electrical machines 1200 and 1202 are driven as the power generators, rotors of the rotating electrical machines 1200 and 1202 are rotationally driven by a rotating torque applied from the external, and a three-phase AC power is generated in stator windings of the rotating electrical machines 1200 and 1202. The generated three-phase AC power is converted into the DC power by the power conversion device 1600, and the DC power is supplied to the high-voltage battery 1180 to charge the battery 1180.

In the above-mentioned embodiments and their modified examples, any combinations of the respective embodiments together or the embodiments and the modified embodiments can be conducted.

The above-mentioned embodiments and modified examples can obtain the following advantages.
In the assembled battery 102 having the plurality of batteries 101 electrically connected in series, and the discharge circuit electrically connected in parallel to the respective batteries 101 to discharge the respective batteries 101, there are provided a discharge circuit having the first resistor 203 and the discharge switch 202 electrically connected in series, the comparators 204 and 214 that compare voltages of the respective batteries 101 with a given voltage through the first resistor 203, and the diagnostic circuit (103 or 105) that conducts the fault diagnosis of the discharge switch 202 on the basis of the comparison results of the comparators 204 and 214. With this configuration, the magnitude of the current flowing the discharge switch 202 for equalizing the variation in the amount of charge, which is externally attached to the IC, can be determined by the comparators 204 and 214 incorporated into the IC. Further, because the lines necessary for the comparators 204 and 214, and the existing lines necessary for measurement of the battery voltage or determination of the overdischarge can be commonalized, the diagnosis of the discharge switch 202 can be realized without increasing the number of pins in the IC.

The content of following priority application is hereby incorporated by reference into this application.
Japanese Patent Application No. 2010-236472 (filed on October 21, 2010).

## Claims

1. A battery system, comprising:
an assembled battery having a plurality of batteries connected in series;
a discharge circuit having a first resistor and a discharge switch connected in series, which is connected in parallel to the respective batteries to discharge the respective batteries;
a comparator that compares voltages of the respective batteries with a given voltage through the first resistor; and
a diagnostic circuit that conducts a fault diagnosis of the discharge switch on the basis of comparison results of the comparator.

2. The battery system according to claim 1,
wherein the diagnostic circuit conducts the fault diagnosis of the first switch on the basis of the comparison results of the comparator when conducting an intermittent operation of the discharge switch.

3. The battery system according to claim 2,
wherein the diagnostic circuit diagnoses that the discharge switch is in failure if an output of the comparator is not changed when conducting the intermittent operation of the discharge switch.

4. The battery system according to any one of claims 1 to 3, further comprising:
a voltage measurement circuit that measures the voltages of the respective batteries,
wherein there is provided a first common portion that communizes at least a part of a line for connecting the batteries to the discharge circuit, and at least a part of a line for connecting the batteries to the voltage measurement circuit.

5. The battery system according to claim 4,
wherein there is provided a second common portion that communizes at least a part of the line for connecting the batteries to the voltage measurement circuit, and at least a part of a line for controlling the discharge circuit.

6. The battery system according to claim 5,
wherein a second resistor is disposed between the first common portion and the second common portion.

7. The battery system according to claim 6,
wherein a third resistor is disposed between the first resistor and the discharge switch, and
wherein the comparator is connected at a connection point between the first resistor and the third resistor.

8. The battery system according to claim 7,
wherein the comparator is connected from the connection point of the first resistor and the third resistor through a fourth resistor.

9. The battery system according to any one of claims 1 to 8, wherein the diagnostic circuit conducts the fault diagnosis of the discharge switch when starting the battery system.

10. The battery system according to any one of claims 1 to 9, wherein a voltage at which the battery is in an overdischarging state is set for the given voltage of the comparator.
